# EUROPÄISCHE PATENTANMELDUNG

(11) **EP 1 468 934 A2**
(43) Veröffentlichungstag der Anmeldung: **20.10.2004**
(21) Anmeldenummer: 04006955.1
(22) Anmeldetag: 23.03.2004
(51) Int. Cl.: B65D 73/02, H05K 13/00

(54) **Transportgurt**

(30) Priorität: 16.04.2003 DE 10317811
(71) Anmelder: Patent -Treuhand-Gesellschaft für elektrische Glühlampen mbH, 81543 München (DE)
(72) Erfinder: Lang, Richard, 85125 Kinding (DE)

(57) **Zusammenfassung**

Offenbart ist ein Transportgurt (2) zur Aufnahme von elektronischen oder optoelektronischen Bauteilen mit einer Vielzahl von Taschen (16) zur Aufnahme der Bauteile und einer Vielzahl von schwenkbaren oder verschiebbaren Deckeln (6) zum Verschließen der Taschen (16).

## Beschreibung

### I. Technisches Gebiet

Die Erfindung betrifft einen Transportgurt nach dem Oberbegriff des Patentanspruchs 1. Transportgurte zur Aufnahme von elektronischen oder optoelektronischen Bauteilen als Vor- und Zwischenerzeugnisse, wie bspw. Wendeln, dienen zum sicheren Transport und zum sicheren Zuführen der Bauteile zu Produktionsmaschinen.

Die Transportgurte sind meist als Blistergurte mit Taschen zur Aufnahme der Bauteile versehen. Um ein Herausfallen der Bauteile aus den Taschen zu verhindern, sind diese über eine auf dem Transportgurt aufzutragende Einwegfolie, wie eine Heißsiegelfolie oder eine selbstklebende Kaltsiegelfolie, verschlossen. Vorzugsweise werden die befüllten Transportgurte auf einer Rolle zusammengerollt und so einem Feeder zur weiteren Verarbeitung der Bauteile übergeben. Im Feeder wird die Abdeckung vom Transportgurt abgezogen, die Bauteile werden entnommen und die abgezogene Abdeckung und der geleerte Transportgurt werden einem Schneidegerät zur Zerkleinerung zugeführt.

Nachteilig an diesen bekannten Transportgurten ist, daß derartige Transportgurte und Abdeckungen nicht wieder verwendbar sind.

### II. Stand der Technik

Eine Lösung eines wiederverwertbaren Transportgurtes ist in der DE 42 07 496 C1 beschrieben. Dieser Transportgurt dient vornehmlich zur Aufnahme von Miniaturglühlampen. Die Miniaturglühlampen sind über Transportgurtzungen, die die Miniaturglühlampen abschnittsweise brückenartig übergreifen, auf dem Transportgurt gesichert.

An dieser Lösung ist nachteilig, daß die aufzunehmenden Bauteile bestimmte geometrische Kriterien erfüllen müssen, um von den brückenartigen Transportgurtzungen umgriffen werden zu können. Des Weiteren ist nachteilig, daß bei dieser Lösung die Bauteile ungeschützt auf der Oberfläche der Transportgurtes angeordnet sind.

### III. Darstellung der Erfindung

Aufgabe der vorliegenden Erfindung ist es, einen Transportgurt zu schaffen, der die vorgenannten Nachteile beseitigt und eine sichere Aufnahme von elektronischen oder optoelektronischen Bauteile ermöglicht.

Diese Aufgabe wird gelöst durch einen Transportgurt mit den Merkmalen nach dem Patentanspruch 1 bzw. 9. Besonders vorteilhafte Ausführungen der Erfindung sind in den abhängigen Patentansprüchen offenbart.

Der erfindungsgemäße Transportgurt besitzt eine Vielzahl von nebeneinander angeordneten Taschen zur Aufnahme der zu transportierenden Bauteile, wobei die Taschen über eine Abdeckung verschließbar sind. Erfindungsgemäß wird die Abdeckung entweder von einer Vielzahl von Deckeln gebildet, die schwenkbar an dem Transportgurt angeordnet sind, oder die Abdeckung ist verschiebbar entlang des Transportgurtes ausgebildet.

Bei den erfindungsgemäßen Transportgurten können die Taschen nach jeder Bauteilentnahme erneut befüllt und mittels der Deckel bzw. der verschiebbaren Abdeckung erneut verschlossen werden, so daß der Transportgurt wieder verwendet werden kann. Folglich können die Kosten für Verpackung und Zuführung gesenkt werden.

Des Weiteren können im Gegensatz zu herkömmlichen Transportgurten mit einer Einwegfolie als Abdeckung die Deckel einzeln geöffnet und verschlossen werden. Weiterhin sind sie schneller verschließbar, so daß kürzere Produktionszeiten realisierbar sind.

Ferner sind die Bauteile geordnet und geschützt in den Taschen aufgenommen, so daß sich die erfindungsgemäßen Transportgurte besonders für die Bauteile anbieten, die bei einer herkömmlichen Vibrationszuführung als problematisch gelten.

Bei einer bevorzugten Ausführungsform ist der Transportgurt ein Blistergurt, an dem die Deckel über Gelenke am Transportgurt gelagert sind. Bevorzugterweise sind die Gelenke einstückig am Transportgurt ausgeformt und als eine Art Filmscharnier in Form einer Materialverjüngung ausgebildet.

Die Deckel sind vorzugsweise über Kraft- und/oder Formschluß in Schließstellung gegen Öffnen gesichert. Somit ist eine versehentliche Benetzung bzw. Verschmutzung der Bauteile mit Klebstoff, wie bei bekannten Stoffschlußverbindungen bei Verwendung einer Einwegfolie, ausgeschlossen.

Idealerweise haben die Deckel jeweils einen Vorsprung, der in die Taschen eingreift und flächig mit Außenumfangsabschnitten an Innenumfangsabschnitten der Taschen anliegt und somit klemmt. Bei einer Ausführungsform weisen die Taschen und die Vorsprünge eine Quaderform auf. Gemäß der besonders bevorzugten Ausführungsbeispiele der Erfindung ist die Form der Taschen an die Kontur der zu transportierenden Gegenstände angepasst.

Zum sicheren und störungsfreien Führen des Transportgurtes auf einer Rolle oder in einem Zuführungsautomaten (Feeder) sind an dem Transportgurt Führungsausnehmungen vorgesehen.

Bei zwei bevorzugten Ausführunsgbeispielen der Erfindung ist der Transportgurt aus zwei Gurten, einem Bauteilegurt, der mit den Taschen für die zu transportierenden Bauteile ausgestattet ist, und einem Gurt zum Verschließen dieser Taschen aufgebaut. Gemäß des ersten dieser beiden Ausführungsbeispiele ist der Gurt zum Verschließen der Taschen als Deckelgurt ausgebildet, der mit einer Vielzahl von schwenkbaren Deckeln ausgestattet ist. Der Deckelgurt ist vorteilhafterweise durch Nieten oder Schweißen mit dem Bauteilegurt verbunden. Gemäß des anderen Ausführungsbeispiels ist der Gurt zum Verschließen der Taschen als Abdeckung ausgebildet, die verschiebbar entlang des Bauteilegurtes angeordnet ist. Durch Verschieben des Verschlußgurtes entlang des Bauteilegurtes werden dessen Taschen nacheinander geöffnet bzw. verschlossen. Der Aufbau des Transportgurtes aus einem Bauteilegurt und einem zweiten Gurt zum Verschließen der Taschen hat den Vorteil, dass der Transportgurt sich auf einfache Weise fertigen lässt und eine hohe Anzahl von Wiederverwendungen ermöglicht. Außerdem könnten dadurch die verschleißbehafteten Teile des Transportgurtes, wie zum Beispiel der Gurt zum Verschließen der Taschen aus Metall, insbesondere aus einem Metallband, bestehen und der weniger beanspruchte Bauteilegurt aus Kunststoff bestehen. Insbesondere bestehen die Deckelscharniere des Deckelgurtes vorteilhafterweise aus Metall. Um die ebenfalls verschleißbehafteten Führungsausnehmungen, die zum sicheren Führen des Transportgurtes auf einer Rolle oder in einem Zuführautomaten dienen, zu schützen, können diese Führungsausnehmungen beispielsweise mittels eines darüber angeordneten metallischen Lochstreifens verstärkt werden. Statt der Verwendung des vorgenannten metallischen Lochstreifens kann aber auch der Bauteilegurt, der vorzugsweise mit den Führungsausnehmungen versehen ist, oder der gesamte Transportgurt aus Metall bzw. Metallbändern bestehen.

Gemäß einer weiteren bevorzugten Ausführungsform der Erfindung ist der Transportgurt mit einer Abdeckung für die Taschen versehen, die aus einer Vielzahl von entlang des Transportgurtes verschiebbar angeordneten Deckeln besteht. Diese Deckel decken mindestens eine Tasche, vorzugsweise genau eine Tasche, ab und sind vorzugsweise jeweils einzeln entlang des Transportgurtes verschiebbar. Sie sind beispielsweise jeweils mittels einer Schnapp- oder Rastverbindung an den Seitenkanten des Transportgurtes fixiert.

### IV. Beschreibung der bevorzugten Ausführungsbeispiele

Im Folgenden erfolgt eine nähere Erläuterung der Erfindung anhand schematischer Darstellungen. Es zeigen
- Figur 1: Eine perspektivische Gesamtansicht eines ersten Ausführungsbeispiels des Transportgurtes in geöffneter Position,
- Figur 2: Eine perspektivische Gesamtansicht des Transportgutes gemäß Figur 1 in Zwischenpositionen und
- Figur 3: Eine perspektivische Gesamtansicht des Transportgurtes gemäß Figur 1 in verschlossener Position.
- Figur 4: Eine perspektivische, schematische Darstellung eines Abschnitts des zweiten Ausführungsbeispiels des erfindungsgemäßen Transportgurtes
- Figur 5: Einen Querschnitt durch den in Figur 4 abgebildeten Transportgurt
- Figur 6: Eine Draufsicht auf ein drittes Ausführungsbeispiel des erfindungsgemäßen Transportgurtes
- Figur 7: Eine Seitenansicht des in Figur 6 abgebildeten Transportgurtes
- Figur 8: Einen Querschnitt durch den in Figur 6 abgebildeten Transportgurt
- Figur 9: Eine Draufsicht auf ein viertes Ausführungsbeispiel des erfindungsgemäßen Transportgurtes
- Figur 10: Eine Seitenansicht des in Figur 9 abgebildeten Transportgurtes
- Figur 11: Einen Querschnitt durch den in Figur 9 abgebildeten Transportgurt

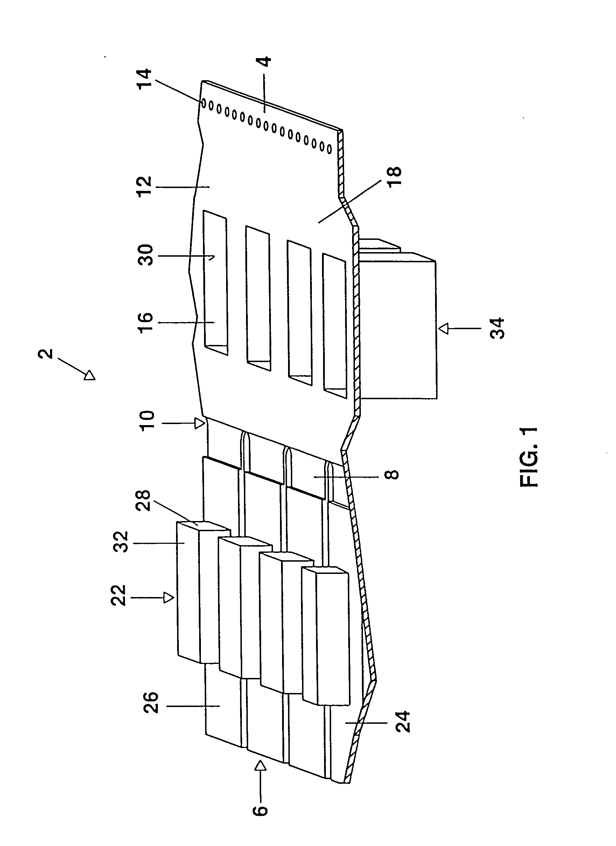

Das erste, in Figur 1 abgebildete Ausführungsbeispiel des erfindungsgemäßen Transportgurtes 2 ist als Blistergurt zur Aufnahme von elektronischen oder optoelektronischen Bauteilen, beispielsweise Halbleiterbauteilen, (nicht dargestellt) ausgebildet. Der Transportgurt 2 hat eine Basis 4 und eine Vielzahl von sich laschenförmig von der Basis 4 weg erstreckenden Deckeln 6.

Die Basis 4 ist mit einer Vielzahl von in Längsrichtung des Transportgurtes 2 nebeneinander angeordneten Taschen 16 versehen. Diese Taschen 16 sind vorzugsweise tiefgezogen und bilden jeweils einen becherartigen hohlen Körper, der von der Vorderseite 18 der Basis 4 her zugänglich ist. Vorzugsweise sind die Taschen 16 quaderförmig jedoch sind auch kugelartige oder ellipsoide Taschen 16 vorstellbar. Die Größe der Taschen 16 ist idealerweise so bemessen, daß jeweils in einer Tasche 16 ein Bauteil aufgenommen werden kann.

Die Deckel 6 dienen zum Verschließen der Taschen 16. Sie sind jeweils über ein Gelenk 8 schwenkbar an einer Längsseite 10 der Basis 4 befestigt. Die Gelenke 8 sind einstückig mit der Basis 4 und den Deckeln 6 ausgebildet und vorzugsweise als Filmscharniere über eine Materialverjüngung gegenüber der Basis 4 und den Deckeln 6 ausgeformt.

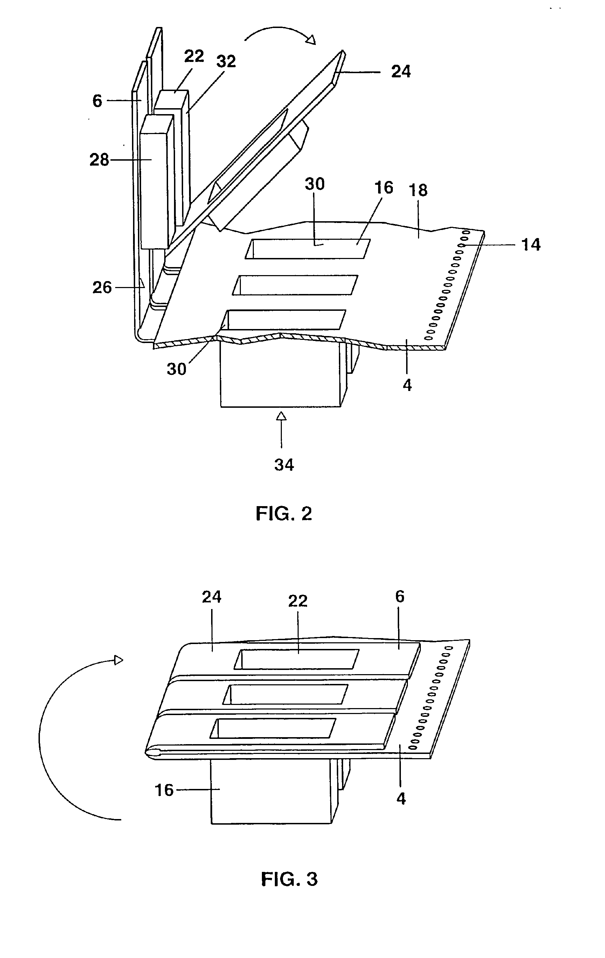

Die Deckel 6 haben jeweils einen Vorsprung 22, der an einer Unterseite 26 des Deckels 6 ausgebildet ist und in Schließstellung (Figur 3) über eine Schwenkbewegung der Deckel 6 (Figur 2) in die Taschen 16 eintauchen kann. Die Außenmaße der Vorsprünge 22 sind so gewählt, daß sie reibschlüssig in den Taschen 16 aufgenommen werden, wodurch ein wiederholtes Öffnen und Schließen der Taschen 16 und somit eine erneute Verwendung des Transportgurtes 4 ermöglicht ist. Die Vorsprünge 22 sind entsprechend der Form der Taschen 16 quaderförmig. In verschlossener Position klemmen die Vorsprünge 22 vorzugsweise flächig mit Außenumfangabschnitten 28 an Innenumfangsabschnitten 30 der Taschen 16. Aufgrund der geringeren Tiefe der Vorsprünge 22 im Vergleich zu den Taschen 16 sind die Vorsprünge 22 mit ihren Bodenflächen 32 von gegenüberliegenden Bodenflächen 34 der Taschen 16 beabstandet, so daß sich ein Zwischenraum für die Aufnahme der Bauteile bildet.

Um den Transportgurt 2 möglichst einfach herstellen zu können und um Gewicht zu sparen, sind die Vorsprünge 22 von einer Oberseite 24 der Deckel 6 aus betrachtet hohl ausgearbeitet. Die Länge der Deckel 6 ist so gewählt, daß in verschlossener Position die Führungsausnehmungen 14 nicht von den Deckeln 6 verdeckt werden (Figur 3).

An dem von den Deckeln 6 abgewandten Langsseitenbereich 12 der Basis 4 sind Führungsausnehmungen 14 in Form von Perforationen zum sicheren Führen des Transportgurtes beispielsweise auf einer Rolle oder in einem Feeder vorgesehen.

Es ist jedoch auch vorstellbar, die Deckel 6 und die Basis 4 getrennt voneinander herzustellen und die Deckel 6 durch Stoffschluß, wie z. B. Schweißen, an der Basis 4 zu befestigen.

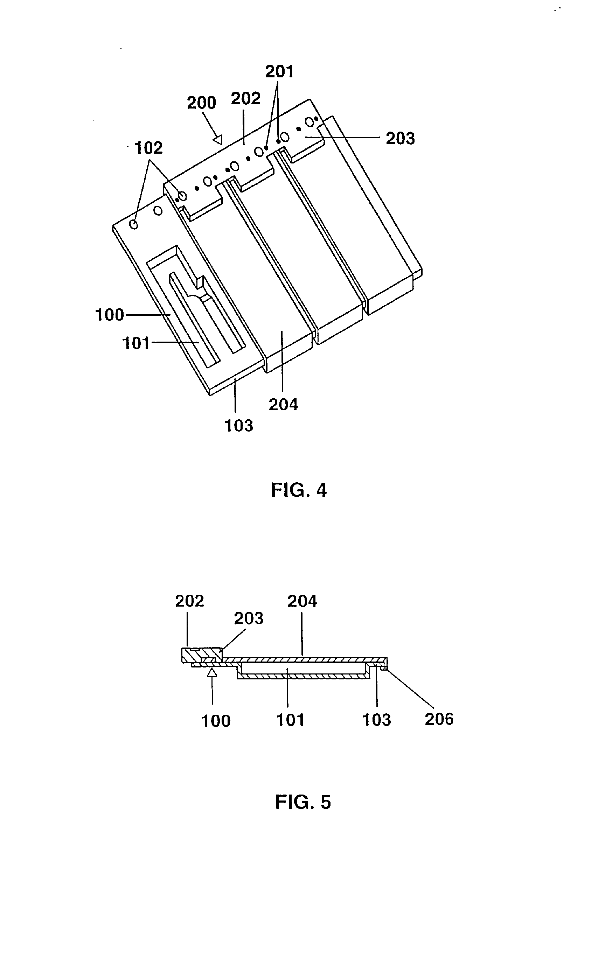

In den Figuren 4 und 5 ist schematisch ein zweites Ausführungsbeispiel des erfindungsgemäßen Transportgurtes dargestellt, der zum Transport von Glühwendeln für Glühlampen dient. Dieser Transportgurt besitzt ein aus einem Kunststoff- oder Metallband bestehenden Bauteilegurt 100, der eine Vielzahl von nebeneinander angeordneten, tiefgezogenen Taschen oder Bauteilenestem 101 aufweist. Diese Taschen oder Bauteilenester 101 dienen zur Aufnahme jeweils einer Glühwendel (nicht abgebildet). Die Dicke und das Material des Kunststoff- oder Metallbandes, aus dem der Bauteilegurt 100 gefertigt ist, ist derart gewählt, dass der Bauteilegurt 100 ausreichend flexibel ist, um ihn auf einer Vorratsrolle aufrollen zu können, und außerdem eine ausreichende Formstabilität besitzt. Die Form der Bauteilenester 101 ist an die äußere Kontur der zu transportierenden Glühwendel angepasst. Die Bauteilenester 101 sind hintereinander, in gleicher Orientierung auf dem Bauteilegurt 100 angeordnet, so dass die in den Nestern 101 angeordneten Glühwendeln von dem Greifwerkzeug einer automatisierten Fertigungsanlage entnommen werden können. Entlang einer Seitenkante des Bauteilegurtes 100 sind im gleichen Abstand, über die gesamte Länge des Bauteilegurtes 100 Führungsausnehmungen 102 angeordnet, die zum Führen des Bauteilegurtes 100 bzw. des Transportgurtes in einem Feeder dienen.

Auf der Oberseite des Bauteilegurtes 100 ist ein Deckelgurt 200 mittels Nieten 201 befestigt. Der Deckelgurt 200 besteht aus einem gelochten Streifen 202, der mit einer Vielzahl von Löchern 205, einer Vielzahl von Scharnieren 203 und einer Vielzahl von um die Scharniere 203 schwenkbar angeordneten Deckeln 204 versehen ist. Die Löcher 205 dienen zum Führen des Deckelgurtes 200. Nach der Montage des Deckelgurtes 200 auf dem Bauteilegurt 100 sind die Löcher 205 deckungsgleich über den Führungsausnehmungen 102 des Bauteilegurtes 100 angeordnet. Die Deckel 204 dienen zum Verschließen der Bauteilenester 101 des Bauteilegurtes 100. Die Deckel 204 besitzen zu diesem Zweck einen Schnapper 206, der an der den Scharnieren 203 und den Führungsausnehmungen 102 gegenüberliegenden Seitenkante 103 des Bauteilegurtes 100 hinterrastet. Der gelochte Streifen 202 mit den Scharnieren 203 besteht vorzugsweise aus einem Metallband, während die Deckel 204 vorzugsweise aus Kunststoff gefertigt sind. Es ist aber auch möglich, den gesamten Transportgurt aus demselben Material, beispielsweise einem Kunststoff oder einem Metall herzustellen. Anstatt der Scharniere 203 können die Deckel 204 auch mit Filmgelenken, wie im ersten Ausführungsbeispiel beschrieben wurde, ausgestattet werden.

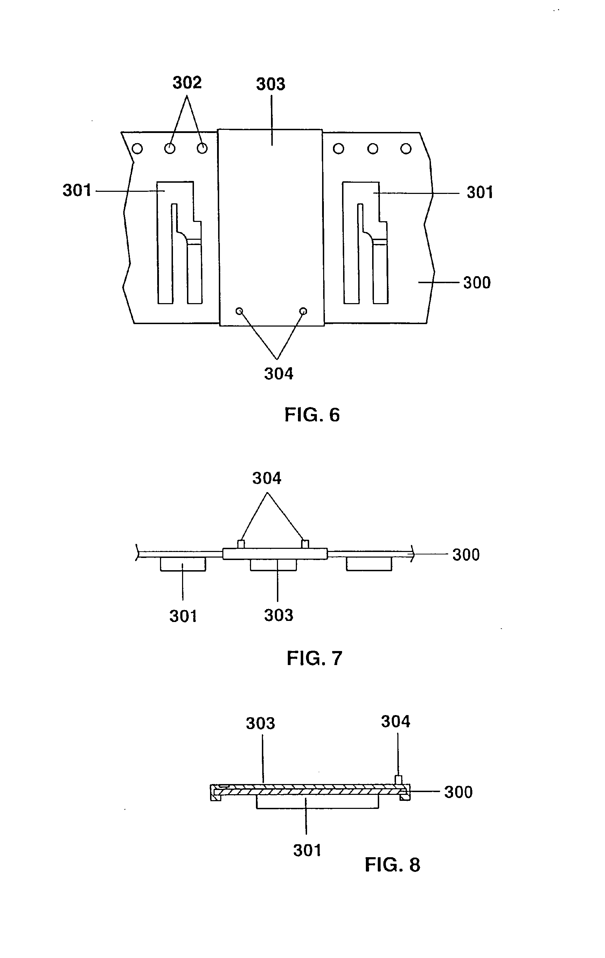

In den Figuren 6 bis 8 ist ein drittes Ausführungsbeispiel des erfindungsgemäßen Transportgurtes dargestellt. Dieser Transportgurt besitzt ein aus einem Kunststoffoder Metallband bestehenden Bauteilegurt 300, der eine Vielzahl von nebeneinander angeordneten, tiefgezogenen Taschen oder Bauteilenestern 301 aufweist. Diese Taschen oder Bauteilenester 301 dienen zur Aufnahme jeweils einer Glühwendel (nicht abgebildet). Die Dicke und das Material des Kunststoff- oder Metallbandes, aus dem der Bauteilegurt 300 gefertigt ist, ist derart gewählt, dass der Bauteilegurt 300 ausreichend flexibel ist, um ihn auf einer Vorratsrolle aufrollen zu können, und außerdem eine ausreichende Formstabilität besitzt. Die Form der Bauteilenester 301 ist an die äußere Kontur der zu transportierenden Glühwendel angepasst. Die Bauteilenester 301 sind hintereinander, in gleicher Orientierung auf dem Bauteilegurt 300 angeordnet, so dass die in den Nestern 301 angeordneten Glühwendeln von dem Greifwerkzeug einer automatisierten Fertigungsanlage entnommen werden können. Entlang einer Seitenkante des Bauteilegurtes 300 sind im gleichen Abstand, über die gesamte Länge des Bauteilegurtes 300 Führungsausnehmungen 302 angeordnet, die zum Führen des Bauteilegurtes 300 bzw. des Transportgurtes in einem Feeder dienen.

Auf dem Bauteilegurt 300 sind eine Vielzahl von Deckeln 303 verschiebbar entlang des Bauteilegurtes 300 angeordnet. Die Deckel 303 sind so ausgebildet, dass sie jeweils eine Tasche bzw. ein Bauteilenest 301 abdecken können, wenn sie entsprechend darüber platziert werden. Die Deckel 303 umgreifen die Seitenkanten des Bauteilegurtes 300 derart, dass sie entlang des Bauteilegurtes 300, ähnlich wie auf einer Schiene, verschiebbar sind. Auf der Oberseite der Deckel 303 sind jeweils zwei Noppen 304 angeordnet, die zum Verschieben der Deckel 303 mittels eines Automaten oder einer Fertigungsmaschine relativ zum Bauteilegurt 300 dienen. Anstelle von Noppen 304 können die Deckel 303 aber auch mit Führungsausnehmungen ausgestattet werden, die sich von den Führungsausnehmungen des Bauteilegurtes 300 unterscheiden. Die Deckel 303 bestehen aus Kunststoff oder Metall. Zur Entnahme der in den Taschen bzw. Nestern 301 angeordneten Bauteile werden die Deckel 303 jeweils um eine Position verschoben, d. h. auf das unmittelbar vorher geleerte Bauteilenest 301 geschoben. Nach dem vollständigen Entleeren des Transportgurtes ist das letzte Bauteilenest 301 offen. Das erneute Bestücken des Transportgurtes erfolgt daher in umgekehrter Reihenfolge. Die Deckel werden beim Bestücken des Transportgurtes jeweils um eine Position auf das soeben bestückte Bauteilenest 301 geschoben. Dadurch wird das soeben bestückte Bauteilenest abgedeckt und gleichzeitig das benachbarte Bauteilenest für die Bestückung geöffnet.

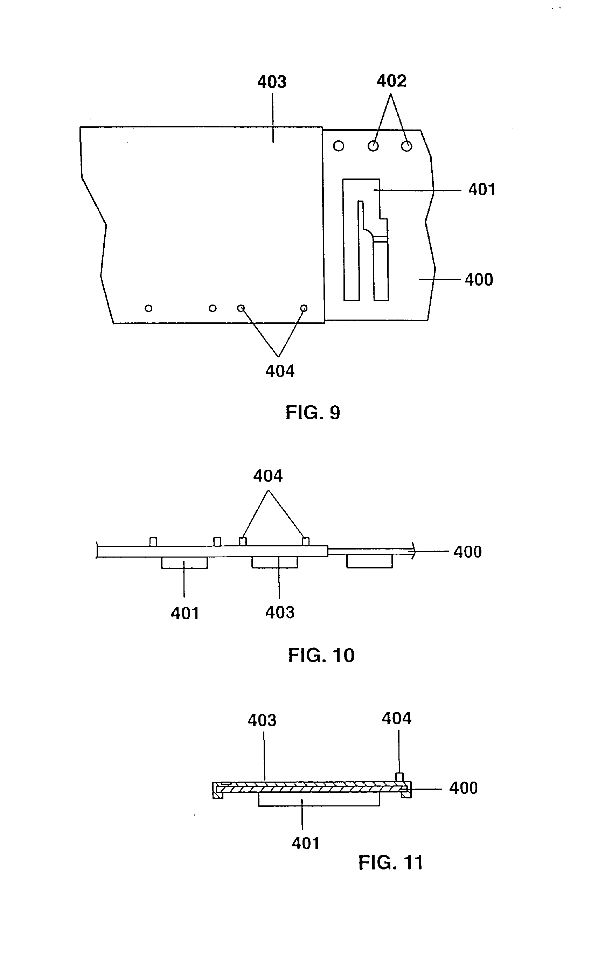

In den Figuren 9 bis 11 ist ein viertes Ausführungsbeispiel des erfindungsgemäßen Transportgurtes dargestellt. Dieser Transportgurt besitzt ein aus einem Kunststoffoder Metallband bestehenden Bauteilegurt 400, der eine Vielzahl von nebeneinander angeordneten, tiefgezogenen Taschen oder Bauteilenestern 401 aufweist. Diese Taschen oder Bauteilenester 401 dienen zur Aufnahme jeweils einer Glühwendel (nicht abgebildet). Die Dicke und das Material des Kunststoff- oder Metallbandes, aus dem der Bauteilegurt 400 gefertigt ist, ist derart gewählt, dass der Bauteilegurt 400 ausreichend flexibel ist, um ihn auf einer Vorratsrolle aufrollen zu können, und außerdem eine ausreichende Formstabilität besitzt. Die Form der Bauteilenester 401 ist an die äußere Kontur der zu transportierenden Glühwendel angepasst. Die Bauteilenester 401 sind hintereinander, in gleicher Orientierung auf dem Bauteilegurt 400 angeordnet, so dass die in den Nestern 401 angeordneten Glühwendeln von dem Greifwerkzeug einer automatisierten Fertigungsanlage entnommen werden können. Entlang einer Seitenkante des Bauteilegurtes 400 sind im gleichen Abstand, über die gesamte Länge des Bauteilegurtes 400 Führungsausnehmungen 402 angeordnet, die zum Führen des Bauteilegurtes 400 bzw. des Transportgurtes in einem Feeder dienen.

Die Abdeckung der Bauteilenester 401 erfolgt mittels eines Deckelgurtes 403, der verschiebbar auf dem Bauteilegurt 400 angeordnet ist. Der Bauteilegurt 400 und der Deckelgurt 403 bilden zusammen den Transportgurt. Der Deckelgurt 403 umgreift die Seitenkanten des Bauteilegurtes 400, so dass er, wie auf einer Schiene, entlang des Bauteilegurtes 400 verschiebbar ist. Durch Verschieben des Deckelgurtes 403 werden die Taschen bzw. Bauteilenester 401 nacheinander geöffnet bzw. geschlossen. Der Deckelgurt 403 weist auf seiner Oberseite, entlang zumindest einer seiner Seitenkanten eine Vielzahl von Noppen 404 auf, die ein Verschieben des Deckelgurtes 403 relativ zum Bauteilegurt 400 mittels eines Automaten oder einer Fertigungsmaschine ermöglichen. Anstelle von Noppen 404 kann der Deckelgurt 403 aber auch Führungsausnehmungen, die sich von den Führungsausnehmungen 402 des Bauteilegurtes 400 unterscheiden, aufweisen.

## Patentansprüche

1. Transportgurt mit einer Vielzahl von nebeneinander angeordneten Taschen (16; 101) zur Aufnahme der zu transportierenden Bauteile, wobei die Taschen (16; 101) über eine Abdeckung verschließbar sind, **dadurch gekennzeichnet, daß** die Abdeckung von Deckeln (6; 204) gebildet ist, die schwenkbar am Transportgurt (2) angeordnet sind.

2. Transportgurt nach Anspruch 1, **dadurch gekennzeichnet, dass** der Transportgurt einen Bauteilegurt (100) und einen daran fixierten Deckelgurt (200) aufweist, wobei der Bauteilegurt (100) mit den Taschen (101) zur Aufnahme der zu transportierenden Gegenstände versehen ist und der Deckelgurt (200) mit einer Vielzahl der schwenkbaren Deckel (204) ausgestattet ist.

3. Transportgurt nach Patentanspruch 1 oder 2, **dadurch gekennzeichnet, daß** die Deckel (6; 204) über Gelenke (8; 203) am Transportgurt (2) gelagert sind.

4. Transportgurt nach Patentanspruch 3, **dadurch gekennzeichnet, daß** die Gelenke (8) einstückig mit den Deckeln (6) und einer Basis (4) des Transportgurtes (2) ausgebildet sind.

5. Transportgurt nach Patentanspruch 3 oder 4, **dadurch gekennzeichnet, daß** die Gelenke (8) als Filmscharnier ausgebildet sind.

6. Transportgurt nach Patentanspruch 1 oder 2, **dadurch gekennzeichnet, daß** die Deckel (6; 204) über Kraft- und/oder Formschluß in Schließstellung gegen Öffnen gesichert sind.

7. Transportgurt nach Patentanspruch 6, **dadurch gekennzeichnet, daß** die Deckel (6) Vorsprünge (22) aufweisen, die in die Taschen (16) greifen und mit diesen klemmen.

8. Transportgurt nach Patentanspruch 7, **dadurch gekennzeichnet, daß** die Vorsprünge (22) mit Außenumfangsabschnitten (28) flächig an Innenumfangsabschnitten (30) der Taschen (16) anliegen, wobei gegenüberliegende Bodenflächen (32, 34) der Vorsprünge (22) und der Taschen (16) voneinander beabstandet sind, so daß ein Zwischenraum zur Aufnahme der Bauteile ausgebildet ist.

9. Transportgurt mit einer Vielzahl von nebeneinander angeordneten Taschen (301; 401) zur Aufnahme der zu transportierenden Bauteile, wobei die Taschen (301; 401) über eine Abdeckung verschließbar sind, **dadurch gekennzeichnet, dass** die Abdeckung (303; 403) verschiebbar entlang des Transportgurtes ausgebildet ist.

10. Transportgurt nach Anspruch 9, **dadurch gekennzeichnet, dass** der Transportgurt einen Bauteilegurt (400) aufweist, der mit den Taschen (401) zur Aufnahme der zu transportierenden Gegenstände versehen ist, und die Abdeckung (403) als Gurt ausgebildet ist, der am Bauteilegurt (400) angeordnet und entlang des Bauteilegurtes (400) verschiebbar ist.

11. Transportgurt nach Anspruch 9, **dadurch gekennzeichnet, dass** die Abdeckung aus mehreren Deckeln (303) besteht, die jeweils mindestens eine der Taschen (301) abdecken und entlang des Transportgurtes verschiebbar sind.

12. Transportgurt nach Anspruch 2 oder 10, **dadurch gekennzeichnet, dass** der Bauteilegurt (200; 300; 400) aus Kunststoff oder Metall besteht.

13. Transportgurt nach Anspruch 2 oder 10, **dadurch gekennzeichnet, dass** der Deckelgurt (200; 403) aus Kunststoff oder Metall besteht.

14. Transportgurt nach einem der vorhergehenden Patentansprüche, **dadurch gekennzeichnet, daß** der Transportgurt (2) mit Führungsausnehmungen (14; 102; 302; 402) zum Führen des Transportgurtes (2) beispielsweise auf einer Rolle oder in einem Feeder ausgestattet ist.

15. Transportgurt nach einem der vorhergehenden Patentansprüche, **dadurch gekennzeichnet, daß** der Transportgurt (2) ein Blistergurt ist.
